# EUROPEAN PATENT APPLICATION

(11) **EP 3 376 548 A1**
(43) Date of publication of application: **19.09.2018**
(21) Application number: 16863637.1
(22) Date of filing: 09.11.2016
(51) Int. Cl.: H01L 33/60

(54) **LIGHT-EMITTING DIODE DEVICE AND MANUFACTURING METHOD THEREFOR**

(30) Priority: 10.11.2015 US 201562253139 P; 10.11.2015 US 201562253649 P
(71) Applicant: Everlight Electronics Co., Ltd, New Taipei City 23860 (TW)
(72) Inventor: LIN, Chih-min, New Taipei City 23860 (TW); LU, Tsung-lin, New Taipei City 23860 (TW); YU, Wei-tyng, New Taipei City 23860 (TW); YEH, Robert, New Taipei City 23860 (TW); HSIEH, Chung-chuan, New Taipei City 23860 (TW); LIN, Chun-min, New Taipei City 23860 (TW)
(74) Representative: Becker Kurig Straus
(86) International application number: PCT/CN2016/105246
(87) International publication number: WO 2017/080461

(57) **Abstract**

A light emitting diode (LED) device and a method of manufacturing the LED device aforementioned are provided. The LED device (400) includes a LED chip (430), an encapsulant (440) and a ring-shape barrier (450'). The LED chip has a first surface and a reflection surface, and the encapsulant covers the LED chip. Wherein the reflection surface (450a) is inclined with respect to a side surface (430b) of the LED chip. A light output angle can be effectively adjusted, and the needs to re-design lenses when market demand changes may be reduced.

## Description

### BACKGROUND

### Technical Field

The invention relates to a light emitting diode device and a method of manufacturing the same.

### Description of Related Art

Along with evolution of lighting technology and rapid development of light emitting devices, light emitting diode (LED) chips are now adopted for the light emitting devices to act as the light source. The LED chips feature advantages of power saving, long service life, environmental-friendly, fast activation, compact volume, etc., and moreover, power to be achieved by the LED chips gradually increases as technology becomes more mature. Currently, the LED chips have gradually been applied to a variety of light emitting devices to replace the conventional light source, so that the light emitting devices feature the advantage of energy-saving.

For instance, in the packaging method of the high-power white LEDs, blue LEDs are adopted most of the time to be used together with yellow phosphors. The reason that a white LED emits a white light is because a LED chip of the white LED emits a blue light. The blue light is converted into a yellow light after passing through yellow phosphors, and the yellow light converted by the yellow phosphors is mixed with the blue light which is not converted so as to generate the white light. In the structure of an existing LED device, a LED chip is fixed to a holder having a reflector cup most of the time and is packaged by light transmissive resin. Nevertheless, the current trend puts increasing emphasis on the development of chip scale package (CSP). That is, from a top view, the area of the packaged LED device can not excessively exceed (e.g., equal to or less than 1.4 times of) the area of the LED chip. Further, the demand for chip sizes changes gradually as well. Under such premise, it is difficult for the current packaging method to adjust holder design any time corresponding to chip sizes. Hence, the costs of using a holder with a cup to achieve the CSP are relatively high for the manufacturers. In addition, in the existing CSP, a substrate is required for packaging. That is, certain limitations are placed on the thickness, and that demand from down-stream manufacturers cannot be satisfied gradually. An effective solution capable of forming the CSP at any time corresponding to chip sizes and reducing the thickness of the products is urgently needed.

In another aspect, although the light output angle of the LED device may be changed through adding additional lenses, most of the manufacturers choose to re-design the lenses to satisfy market demand when facing different customer demand conditions. Nevertheless, the market demand conditions change day by day, the costs of re-designing the lenses gradually increase, another method is thereby needed to replace the method of re-designing the lenses. In view of the above problems, the invention provides a LED device and a method of manufacturing the same so as to effectively adjust the light output angle and reduce the needs to re-design the lenses when market demand changes.

### SUMMARY

The invention provides a light emitting diode (LED) device capable of forming chip scale packaging corresponding to chip sizes at any time and including a ring-shape barrier with reflectivity so as to increase light output effect of the LED device. In an embodiment of the invention, a LED device includes a substrate, a LED chip, an encapsulant covering the LED chip, and a ring-shape barrier surrounding the encapsulant, wherein a height of the ring-shape barrier is equal to a height of the encapsulant.

In an embodiment of the invention, the invention provides a method of manufacturing the LED device, and the method includes the following steps. A plurality of LED chips are disposed on a carrier, and each of the LED chips has a first surface. An encapsulant is formed on the carrier. The encapsulant is cut to form a trench between the LED chips. A reflection colloid is filled in the trench, and the reflection colloid is filled to be as high as the encapsulant. The reflection colloid is cut along the trench so that the reflection colloid becomes a plurality of ring-shape barriers, and the LED device is singulated.

In addition, in order to satisfy the demand for slim design, the invention further provides a LED device without a substrate to reduce product thickness. In an embodiment of the invention, a LED device without a substrate includes a LED chip, an encapsulant covering the LED chip, and a ring-shape barrier surrounding the encapsulant, wherein the LED chip has a plurality of electrodes, each of the electrodes has an electrode terminal, and the electrode terminals are exposed outside the encapsulant.

The invention further provides a method of manufacturing the LED device without a substrate, and the method includes the following steps. A light transmissive carrier is provided. A soluble adhesive layer is formed on the light transmissive carrier. A plurality of LED chips are disposed on the soluble adhesive layer, wherein electrode terminals of the LED chips face the soluble adhesive layer. An encapsulant is formed on the soluble adhesive layer, and the encapsulant covers the LED chips but does not cover the electrode terminals. The encapsulant is cut to form a trench between the LED chips. A reflection colloid is filled in the trench, and the reflection colloid is filled to be as high as the encapsulant. The reflection colloid is cut along the trench so that the reflection colloid becomes a plurality of ring-shape barriers, and the LED chips are singulated to form a plurality of LED devices. A light ray is provided and is irradiated to the soluble adhesive layer through the light transmissive carrier so as to reduce adhesiveness of the soluble adhesive layer, and that each of the LED devices are separated from the soluble adhesive layer and the light transmissive carrier, and the electrode terminals of the flip chip are exposed outside the encapsulant.

The invention further provides a LED device in which a height of the ring-shape barrier is not equal to a height of the encapsulant, and the LED device is adapted to include or not to include a substrate in order to effectively adjust a light output angle and reduce the needs to re-design the lenses when market demand changes. In an embodiment of the invention, the LED device includes a LED chip, a substrate (as required), an encapsulant covering the LED chip, and a ring-shape barrier surrounding the encapsulant, wherein a first surface of the LED chip and a second surface of the encapsulant define a first height, a third surface of the encapsulant and the first surface define a second height, and the first height is greater than the second height.

The invention further provides a method of manufacturing the LED device, and the method includes the following steps. A plurality of LED chips are disposed on a carrier, and each of the LED chips has a first surface. An encapsulant is formed on the carrier and covering the LED chips, the encapsulant has a second surface, and the first surface and the second surface define a first height. The encapsulant is cut to form a trench between the LED chips. A reflection colloid is filled in the trench. A portion of the reflection colloid is removed, and that a top surface of the reflection colloid is lower than a top surface of the encapsulant. The reflection colloid is cut along the trench so that the reflection colloid becomes a plurality of ring-shape barriers, wherein the ring-shape barriers correspondingly surround the LED chips and the cut encapsulant, each of the ring-shape barriers has a third surface, and the first surface of each of the LED chips and the corresponding third surface of each of the ring-shape barriers define a second height, wherein the first height is greater than the second height.

To make the aforementioned more comprehensible, several embodiments accompanied with drawings are described in detail as follows.

### BRIEF DESCRIPTION OF THE DRAWINGS

FIG. 1 and FIG. 2 are a three-dimensional view and a cross-sectional view of a light emitting diode (LED) device of a first embodiment of the invention.
FIG. 3A to FIG. 3G are flowcharts of a method of manufacturing the LED device of the first embodiment of the invention.
FIG. 4 is a schematic cross-sectional view of a LED device of the second embodiment of the invention.
FIG. 5A to FIG 5G are flowcharts of a method of manufacturing the LED device of the second embodiment of the invention.
FIG. 6A to FIG. 6F are flowcharts of a method of manufacturing the LED device of the second embodiment of the invention.
FIG. 7A to FIG. 7E are flowcharts of a method of manufacturing the LED device of the second embodiment of the invention.
FIG. 8 and FIG. 9 are a three-dimensional view and a cross-sectional view of a LED device of a third embodiment of the invention.
FIG. 10A and FIG. 10B are flowcharts of a method of manufacturing the LED device of the third embodiment of the invention.
FIG. 11A and FIG. 11B are flowcharts of a method of manufacturing the LED device of the third embodiment of the invention.
FIG. 12 and FIG. 13 are graphs of light output intensity of the LED device of FIG. 9 and other LED devices at each angle on an X axis and a Y axis in a space coordinate system.
FIG. 14 to FIG. 25 are schematic cross-sectional views of a LED device of other variation examples of this embodiment.

### DESCRIPTION OF THE EMBODIMENTS

### First Embodiment

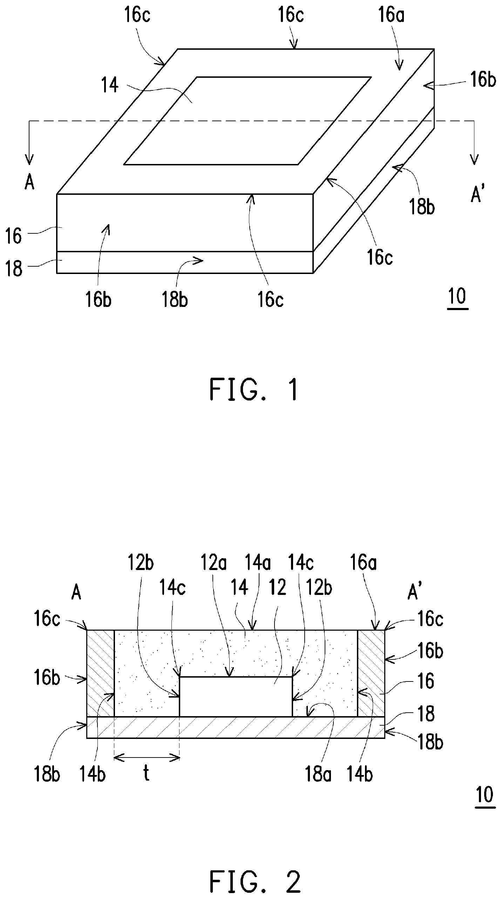

FIG. 1 and FIG. 2 are a three-dimensional view and a cross-sectional view of a light emitting diode (LED) device of a first embodiment of the invention, wherein FIG. 1 is a schematic cross-sectional view taken along a line A-A' of the three-dimensional view of FIG. 2. With reference to FIG. 1 and FIG. 2, a LED device 10 includes a LED chip 12, an encapsulant 14, and a ring-shape barrier 16 in this embodiment. Among them, the encapsulant 14 covers the LED chip 12, and the ring-shape barrier 16 surrounds the encapsulant 14 and the LED chip 12. Further, the LED device 10 includes a substrate 18, and the LED chip 12, the encapsulant 14 are disposed on the substrate 18. Nevertheless, whether the substrate 18 is to be disposed is not limited by the invention, and the LED device may be a LED device without a substrate as described as follows. In addition, the ring-shape barrier 16 is disposed on the substrate 18, and a height of the ring-shape barrier 16 is equal to a height of the encapsulant 14. In this way, the ring-shape barrier 16 surrounds the LED chip 12 and the encapsulant 14 disposed on the substrate 18 and is adapted to reflect light rays emitted by the LED chip 12 and the encapsulant 14. Nevertheless, the height of the ring-shape barrier 16 and the height of the encapsulant 14 are not limited to be equal in this embodiment, and the height of the ring-shape barrier 16 and the height of the encapsulant 14 may be unequal, which is described in detail as follows.

To be specific, in this embodiment, the LED chip 12 may be selected from a horizontal chip, a vertical chip, or a flip chip. The LED chip 12 is preferably selected from a flip chip since a flip chip is not required to be electrically connected to the substrate through a metal wire, which is advantageous for miniaturization. In addition, when the LED chip is a flip chip, methods such as direct bonding, eutectic bonding, golden ball or bump bonding, silver paste or solder paste bonding, etc. may be adopted to perform die bonding so as to be electrically connected to the substrate. The LED chip 12 includes a first surface 12a and a plurality of side surfaces 12b connected to the first surface 12a. Further, the LED chip 12 has a plurality electrodes that are not shown, and each of the electrodes has an electrode terminal configured to be electrically connected to a conductive circuit pattern of the substrate or an external circuit. In addition, the substrate 18 also includes a top surface 18a and a plurality of external side surfaces 18b connected to the top surface 18a and thus is approximately be flat plate-shaped. The substrate 18 may be selected from a ceramic substrate, a plastic substrate, a printed circuit board (PCB), or a metal substrate. The substrate 18 selected from a ceramic substrate, a plastic substrate, or a PCB also includes the conductive circuit pattern that is not shown, such as a connection circuit or a plurality of contact points. In this case, the LED chip 12 is disposed on the top surface 18a of the substrate 18 and is connected to the contact points through the electrode terminals to be electrically connected to the substrate 18. Nevertheless, the invention does not limit the type of the substrate 18 nor a connection method in which the LED chip 12 is connected thereto.

Further, the encapsulant 14 covers the first surface 12a and the side surfaces 12b of the LED chip 12 and is located on the top surface 18a of the substrate 18 in this embodiment. Moreover, the encapsulant 14 is located between the side surfaces of the LED chip 120 and the ring-shape barrier 16, so that the LED chip 12 is not directly in contact with the ring-shape barrier 16. Specifically, the encapsulant 14 may be any solid including a plane (i.e., a non-curved lens), for example, a cuboid, a cube, a trapezoidal prism, etc. for instance, a cuboid is taken as an example in FIG. 1 and FIG. 2 with a thickness of approximately 0.3 millimeters. To be specific, the encapsulant 14 includes a second surface 14a and a plurality of side surfaces 14b connected to the side surface 14a. In this way, the second surface 14a of the encapsulant 14 is disposed on the first surface 12a of the LED chip 12, and the second surface 14a is substantially parallel to the first surface 12a. The side surfaces 14b of the encapsulant 14 are correspondingly disposed on the side surfaces 12b of the LED chip 12 to cover the first surface 12a and the side surfaces 12b of the LED chip 12. That is, the encapsulant 14 covers all external surfaces of the LED chip 12 except for a bottom surface of the LED chip 12 facing the substrate 18. Specifically, a width t of the encapsulant 14 is provided between the side surface 12b of the LED chip 12 and the ring-shape barrier 16. The width t is preferably to be 0.05 to 0.4 times greater than a width of the chip, and more preferably 0.05 to 0.1 times greater corresponding to light shape improvement of the ring-shape barrier 16.

In the invention, the encapsulant 14 is a colloid with light transmittancy, and the material thereof is selected from one of the following groups: a silicone resin composition, an epoxy resin composition, and a combination of the foregoing. A method of forming the encapsulant 14 may include a screen printing process, a molding process, a lamination process, a coating process, or other suitable processes. Taking the lamination process for example, a pre-formed semi-cured prepreg (e.g., a prepreg cured to the B-stage) is stacked on the substrate 18 and the LED chip 12 and then is heated and/or baked. In this way, the encapsulant is formed not through injecting plastic into a mold as in the molding process, so that uneven injection of plastic is avoided. In addition, if the LED chip 12 is a flip chip, the plastic is prevented from unexpectedly flowing to and between an electrode of the flip chip and a carrier when the lamination process is adopted, which may affect electrical connection capability of the flip chip. In addition, a fluorescence material may be included in the encapsulant 14 to absorb and convert part of the light emitted by the LED chip 12 into light of other colors and simultaneously mix the absorbed light with the converted light to produce light of other colors, such as white light. The fluorescence material may be selected from one of or a plurality of the following groups: Sr₅(PO₄)₃Cl:Eu²⁺, (Sr,Ba)MgAl₁₀O₁₇:Eu²⁺, (Sr,Ba)₃MgSi₂O₈:Eu²⁺, SrAl₂O₄:Eu²⁺, SrBaSiO₄:Eu²⁺, CdS:In, CaS:Ce³⁺, Y₃(Al,Gd)₅O₁₂:Ce²⁺, Ca₃Sc₂Si₃O₁₂:Ce³⁺, SrSiON:Eu²⁺, ZnS:Al³⁺,Cu⁺, CaS:Sn²⁺, CaS:Sn²⁺,F, CaSO₄:Ce³⁺,Mn²⁺, LiAlO₂:Mn²⁺, BaMgAl₁₀O₁₇:Eu²⁺, Mn²⁺, ZnS:Cu⁺,Cl⁻, Ca₃WO₆:U, Ca₃SiO₄C₁₂:Eu²⁺, SrₓBa_{y}Cl_{z}Al₂O_{4-z/2}:Ce³⁺,Mn²⁺ (X:0.2, Y:0.7, Z:1.1), Ba₂MgSi₂O₇:Eu²⁺, Ba₂SiO₄:Eu²⁺, Ba₂Li₂Si₂O₇:Eu²⁺, ZnO:S, ZnO:Zn, Ca₂Ba₃(PO₄)₃Cl:Eu²⁺, BaAl₂O₄:Eu²⁺, SrGa₂S₄:Eu²⁺, ZnS:Eu²⁺, Ba₅(PO₄)₃Cl:U, Sr₃WO₆:U, CaGa₂S₄:Eu²⁺, SrSO₄:Eu²⁺,Mn²⁺, ZnS:P, ZnS:P³⁻,Cl⁻, ZnS:Mn²⁺, CaS:Yb²⁺,Cl, Gd₃Ga₄O₁₂:Cr³⁺, CaGa₂S₄:Mn²⁺, Na(Mg,Mn)₂LiSi₄O₁₀F₂:Mn, ZnS:Sn²⁺, Y₃Al₅O₁₂:Cr³⁺, SrB₈O₁₃:Sm²⁺, MgSr₃Si₂O₈:Eu²⁺,Mn²⁺, α-SrO • 3B₂O₃:Sm²⁺, ZnS-CdS, ZnSe:Cu⁺,Cl, ZnGa₂S₄:Mn²⁺, ZnO:Bi³⁺, BaS:Au,K, ZnS:Pb²⁺, ZnS:Sn²⁺,Li⁺, ZnS:Pb,Cu, CaTiO₃:Pr³⁺, CaTiO₃:Eu³⁺, Y₂O₃:Eu³⁺, (Y,Gd)₂O₃:Eu³⁺, CaS:Pb²⁺,Mn²⁺, YPO₄:Eu³⁺, Ca₂MgSi₂O₇:Eu²⁺,Mn²⁺, Y(P,V)O₄:Eu³⁺, Y₂O₂S:Eu³⁺, SrAl₄O₇:Eu³⁺, CaYAlO₄:Eu³⁺, LaO₂S:Eu³⁺, LiW₂O₈:Eu³⁺,Sm³⁺, (Sr,Ca,Ba,Mg)₁₀(PO₄)₆Cl₂:Eu²⁺,Mn²⁺, Ba₃MgSi₂O₈: Eu²⁺,Mn²⁺, ZnS:Mn²⁺,Te²⁺, Mg₂TiO₄:Mn⁴⁺, K₂SiF₆:Mn⁴⁺, SrS:Eu²⁺, Na_{1.23}K_{0.42}Eu_{0.12}TiSi₄O₁₁, Na_{1.23}K_{0.42}Eu_{0.12}TiSi₅O₁₃:Eu³⁺, CdS:In,Te, CaAlSiN₃:Eu²⁺, CaSiN₃:Eu²⁺, (Ca,Sr)₂Si₅N₈:Eu²⁺, Eu₂W₂O₇.

In FIG. 2, a juncture 14c of the second surface 14a and each of the side surfaces 14b of the encapsulant 14 is formed at a right angle. The second surface 14a is shown a flat surface. Nevertheless, in other variations provided by other embodiments that are not shown, the second surface of the encapsulant may be processed to be a rough surface through a roughening process, so as to reduce internal total reflection and increase a proportion of light refraction to change a light output effect. The third surface 16a of the ring-shape barrier 16 may also be designed to be a rough surface, and a degree of roughness of the third surface 16a may be similar to that of the second surface 14a. Nevertheless, the invention is not limited thereto. Those having ordinary skill in the art may change the degrees of roughness of the second surface 14a and the third surface 16a according to application requirements.

In this embodiment, the ring-shape barrier 16 surrounds the encapsulant 14 and the LED chip 12 and is located on the top surface 18a of the substrate 18. Specifically, in the invention, the ring-shape barrier 16 is adapted to reflect a light ray emitted by the LED chip 12 and converted through the fluorescence material in the encapsulant 14. A material of the ring-shape barrier 16 is a resin composition containing reflective particles. The resin composition may be selected from one of the following groups: a silicone resin composition, an epoxy resin composition, and a combination of the foregoing. In addition, the reflective particles may be selected from one of the following groups: TiO₂, SiO², ZnO, ZrO², BN, BaSiO₄, MgO, and a combination of the foregoing. As such, a reflection rate of the light emitted by the LED chip 12 and converted/mixed through the encapsulant and reflected by the ring-shape barrier 16 is greater than 80%, and preferably greater than 95%. In addition, since the ring-shape barrier 16 is configured for reflecting light ray, besides the parameters of the reflective particle composition or the reflection rate and the like, structural design of the ring-shape barrier 16 may also affect the light output effect (e.g., a light output angle) of the LED device 10.

For instance, in the invention, a width of a barrier may slightly affect light-blocking capability of the barrier, so that the barrier is preferably to be formed of a uniform width so as to provide uniform light-blocking capability. For instance, in FIG. 1 and FIG. 2, the ring-shape barrier 16 of a uniform width is shown to surround the encapsulant 14. The width of the barrier is approximately 0.1 millimeters but is not limited thereto. The ring-shape barrier may be formed of an un-uniform width corresponding to different end product needs. To be specific, the ring-shape barrier 16 includes the third surface 16a and a plurality of external side surfaces 16b connected to the third surface 16a. The third surface 16a of the ring-shape barrier 16 surrounds the side surfaces 14b of the encapsulant 14, and the external side surfaces 16b of the ring-shape barrier 16 correspond to the side surfaces 12b of the LED chip 12 and the side surfaces 14b of the encapsulant 14.

In addition, in this embodiment, a juncture 16c of the third surface 16a and each of the external side surfaces 16b of the ring-shape barrier 16 is formed at a right angle. Nevertheless, even though the third surface 16a of the ring-shape barrier 16 in this embodiment is shown as a plane, the invention is not limited thereto. The third surface 16a may be a convex surface, a concave surface, or an inclined surface. In addition, the external side surfaces 16b of the ring-shape barrier 16 may further be flushed with the external side surfaces 18b of the substrate 18, but the invention is not limited thereto. The external side surface 16b of the ring-shape barrier 16 may not be flushed with the external side surfaces 18b of the substrate 18.

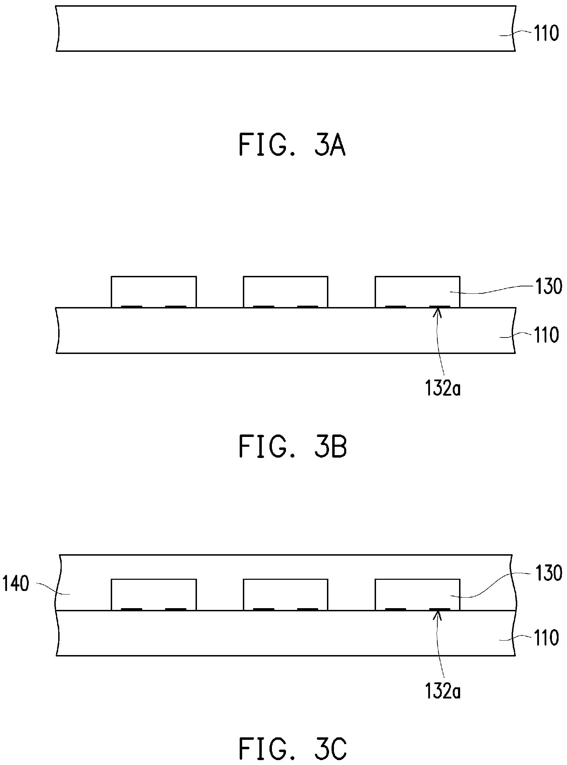

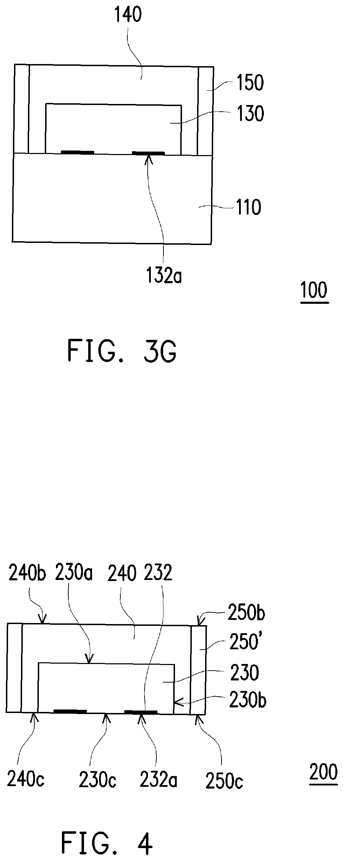

A method of manufacturing the LED device of this embodiment is described in detail with reference to FIG. 3A to FIG. 3G.

FIG. 3A to FIG. 3G are flowcharts of a method of manufacturing the LED device of the first embodiment of the invention. First, a carrier 110 as shown in FIG. 3A to be formed into a substrate in a following singulation step is provided, and thus, a material of the carrier 110 is selected to be identical to that of the substrate. Next, a plurality of LED chips 130 are disposed on the carrier 110 as shown in FIG. 3B. An electrode terminal 132a of each of the LED chips 130 is electrically connected to a conductive circuit pattern (not shown) on the carrier. Three flip chips 130 are schematically illustrated in FIG. 3B and are electrically to the conductive circuit patterns on the carrier through a direct bonding method. Nevertheless, the invention is not intended to limit a number of the LED chips 130. Practically, the number of the LED chips 130 may be greater, and the LED chips 130 may be arranged on the carrier in numeric groups. In this invention, when arranging the LED chips 130, a gap is required to be appropriately calculated and adjusted so as to achieve chip scale packaging after cutting. In other words, the gap between the LED chips 130 is preferably equal to or less than 0.8 times a width of the chip, and is preferable equal to or less than 0.7 times the width of the chip.

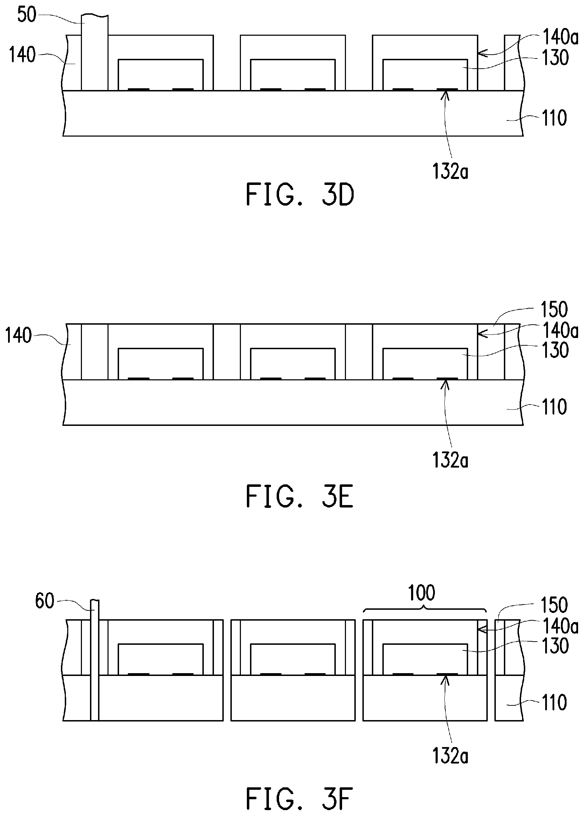

As shown in FIG. 3C, an encapsulant 140 is formed on the carrier 110, wherein the encapsulant 140 covers the LED chips 130. The material selected for and the method of forming the encapsulant 140 are described above. As shown in FIG. 3D, the encapsulant 140 is then pre-cut through a cutting tool 50 to form a patterned trench 140a in the encapsulant 140, wherein each of the LED chips 130 is surrounded by the patterned trench 140a. In addition, in this invention, in a step of cutting the encapsulant 140, the encapsulant 140 is cut in a direction perpendicular to the carrier 110, and that a side surface (i.e., an inner wall of the patterned trench 140a) of the cut encapsulant 140 becomes a plane and is further perpendicular to the carrier 110. Besides, a surface of the carrier 110 may be exposed by the patterned trench 140a, or the surface of the carrier may not be exposed by the patterned trench 140a and thus only a concave structure which is concave towards the carrier 110 is formed. People having ordinary skill in the art may select a depth of the patterned trench according to application features of the end products with reference to the content of the invention.

Next, as shown in FIG. 3E, a reflection colloid 150 is formed in the patterned trench 140a, as such, the reflection colloid 150 is distributed between the LED chips 130, wherein a height of the reflection colloid 150 is proximately identical to that of the encapsulant 140. A material selected for the reflection colloid 150 is identical to the material selected for the ring-shape barrier.

Next, as shown in FIG. 3F, the reflection colloid 150 is cut through a cutting tool 60 to perform singulation to the encapsulant 140 and the LED chips 130 to form a plurality of LED devices 100.

In the invention, a material of the cutting tools 50/60 is selected from one of the following groups: diamond, mental, resin, and a combination of the foregoing. A laser beam may also be used to replace the cutting tool 50/60 for cutting; nevertheless, the cutting tool 50/60 is still preferably used for cutting because undesirable coke contaminant is less likely to be produced.

The LED devices 100 of this invention are formed after the steps shown in FIG. 3A to FIG. 3G. In addition, a quality test may be performed to each of the LED devices 100 to determine whether each of the LED chips 100 achieves the expected light output effect.

The foregoing embodiment describes LED devices having a substrate; nevertheless, a form without a substrate may also be included in the invention. With reference to a second embodiment, the second embodiment describes a LED device of the invention without a substrate as follows.

### Second Embodiment

FIG. 4 is a schematic cross-sectional view of a LED device of the second embodiment of the invention. With reference to FIG. 4, in the second embodiment, a LED device 200 includes a LED chip 230, an encapsulant 240, and a ring-shape barrier 250'. Among them, the encapsulant 240 covers the LED chip 230, and the ring-shape barrier 250' surrounds the encapsulant 240 and the LED chip 230. Further, a height of the ring-shape barrier 250' and a height of the encapsulant 240 are equal, as such, the ring-shape barrier 250' is adapted to reflect light rays emitted by the LED chip 230 and the encapsulant 240. Nevertheless, the height of the ring-shape barrier 250' and the height of the encapsulant 240 are not limited to be equal in this embodiment, and the height of the ring-shape barrier 250' and the height of the encapsulant 240 may be unequal, which is described in detail as follows.

In addition, since the LED device is in a form without a substrate, an electrode terminal 232a of the LED chip 230 is required to be exposed outside the encapsulant 240 to be electrically connected to an external circuit in the second embodiment. As such, the LED chip is preferably a flip chip. Besides, a bottom surface of the LED chip may be exposed outside the encapsulant. Nevertheless, the invention is not limited thereto, and only the electrode terminal is exposed outside the encapsulant, and the bottom surface of the LED chip is encapsulated in the encapsulant. To be specific, the LED chip 230 in FIG. 4 is a flip chip and has a top surface 230a, at least one side surface 230b, and a bottom surface 230c opposite to the top surface 230a. The LED chip 230 has a plurality of electrodes 232, and each of the electrodes 232 has an electrode terminal 232a. The encapsulant 240 covers the top surface 230a of the LED chip 230 but exposes the bottom surface 230c and the electrode terminals 232a. The ring-shape barrier 250' is connected to the encapsulant 240 and is aligned to the side surface 230b of the LED chip 230.

In addition, note that the LED device 200 is a packaging form without a substrate, the electrodes 232 and a bottom surface 240c of the encapsulant 240 are substantially coplanar (i.e., the electrode terminals 232a and the bottom surface 240c are coplanar). Nevertheless, the electrodes 232 are preferably to have a considerable thickness, so that the electrode terminals 232a protrude outwards from the bottom surface 240c of the encapsulant 240. In this way, heat dissipation effect is enhanced, and a soldering area in following applications is simultaneously increased, and that a soldering strength is further enhanced. Nevertheless, an excessive step height may lead to light leakage at the bottom surface 230c. Hence, the step height is preferably between 3µm and 20µm, more preferably between 5µm and 10µm. Besides, in order to prevent the light leakage problem from happening at the chip bottom surface 230c, the electrodes are preferably to cover 50% or greater of an area of the chip bottom surface 230c. Further, in order to allow heat generated by the flip chip owing to light emission to be evenly transmitted to an external heat-dissipation member, areas of the two positive and negative electrodes are preferably to be designed to be equal. A reflection layer may be selectively designed to be included in the flip chip. An area of the reflection layer is required to exceed 50% of the area of the bottom surface, and preferably covers 80% of the area of the bottom surface, so as to solve the light leakage problem which is likely to occur at the chip bottom surface 230c.

Note that since the step height problem may exist between the chip bottom surface 230c, the encapsulant bottom surface 240c, and the ring-shape barrier bottom surface 250c, when the ring-shape barrier is disposed, the area of the encapsulant bottom surface 240c is expected to be lowered as much as possible, so as to prevent the possible light leakage problem from occurring. For instance, the area of the encapsulant bottom surface 240c is preferably to be 20% or less of an area of a light output surface 240b, more preferably 10% or less. Alternatively, a shape of the ring-shape barrier may be additionally designed. For instance, the area of the bottom surface 250c of the ring-shape barrier is increased, and that the bottom surface 250c of the ring-shape barrier is greater than the bottom surface 240c of the encapsulant. In this way, the possibility of light leakage at the bottom surface may also be reduced, and related design of the ring-shape barrier is described through variations provided by other embodiments.

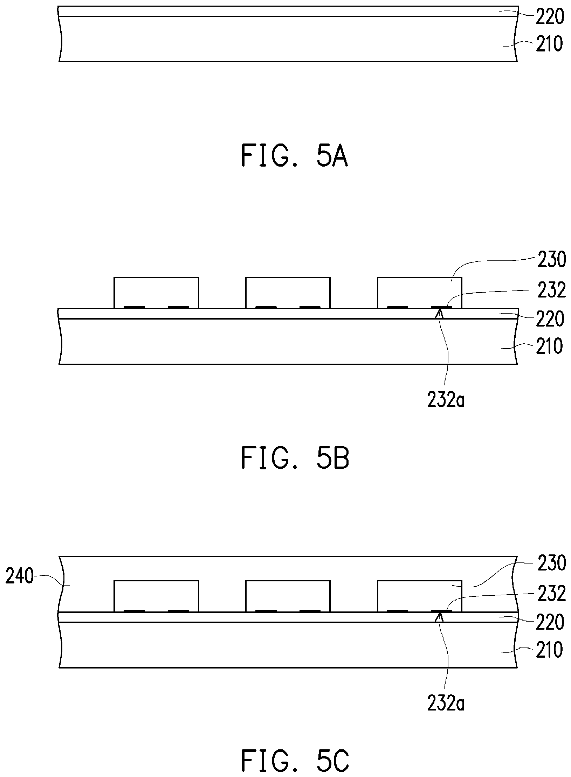

A method of manufacturing the LED device of this embodiment is described in detail with reference to FIG. 5A to FIG. 5G.

First, as shown in FIG. 5A, a light transmissive carrier 210 is provided, and a soluble adhesive layer 220 is formed on the light transmissive carrier 210 through spray coating, brush coating, and soaking, or other suitable methods. The light transmissive carrier 210 may be a glass carrier or a plastic carrier. The soluble adhesive layer 220 may be a photolysis or pyrolysis sticky material, preferably the photolysis sticky material, for example, an ultraviolet light release tape.

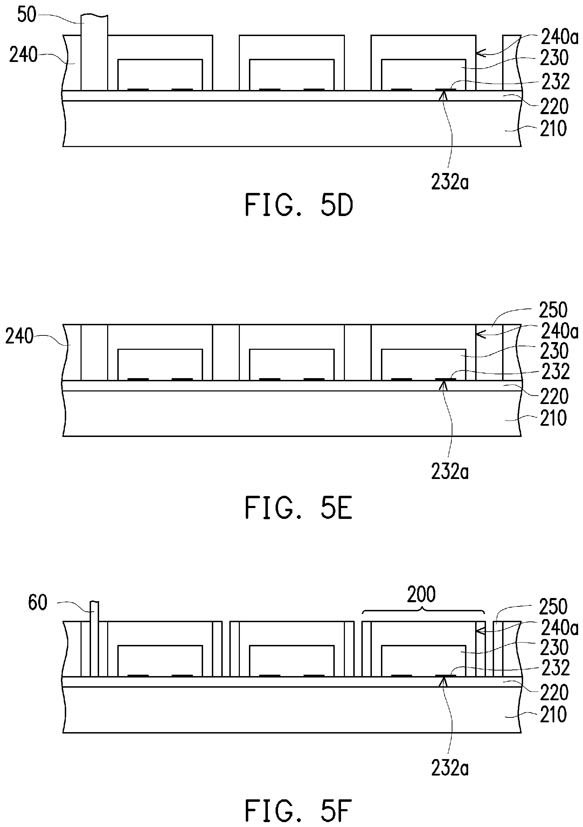

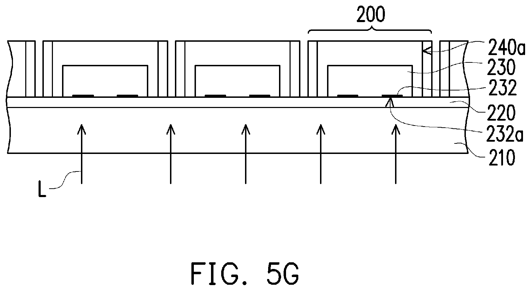

Next, as shown in FIG. 5B, a plurality of LED chips 230 are disposed on the soluble adhesive layer 220, and an electrode terminal 232a of each of the LED chips 230 faces the soluble adhesive layer 220. As shown in FIG. 5C, an encapsulant 240 is then formed on the soluble adhesive layer 220, wherein the encapsulant 240 covers the LED chips 230, and the encapsulant 240 does not cover the electrode terminals 232a of electrodes 232. As shown in FIG. 5D, the encapsulant 240 is then pre-cut through a cutting tool 50 to form a patterned trench 240a in the encapsulant 240, wherein each of the LED chips 230 is surrounded by the patterned trench 240a. As shown in FIG. 5E, a reflection colloid 250 is then formed in the patterned trench 240a, as such, the reflection colloid 250 is distributed between the LED chips 230. As shown in FIG. 5F, the reflection colloid 250 is then cut through a cutting tool 60 to perform singulation to the encapsulant 240 and the LED chips 230 to form a plurality of LED devices 200. Finally, as shown in FIG. 5G, a light ray L is provided, wherein the light ray L is, for example, an ultraviolet light and irradiates the soluble adhesive layer 220 through the light transmissive carrier 210, so as to reduce adhesiveness of the soluble adhesive layer 220. As such, each of the LED devices 200 can be separated from the soluble adhesive layer 220 and the light transmissive carrier 210 so as to be in a state shown in FIG. 4. Accordingly, the LED devices are manufactured without a substrate. After being separated, the electrode terminals 232a of the LED chips 230 are exposed outside the encapsulant 240. In addition, as described above, a quality test may be performed to each of the LED devices 200 to determine whether each of the LED chips 200 achieves the expected light output effect.

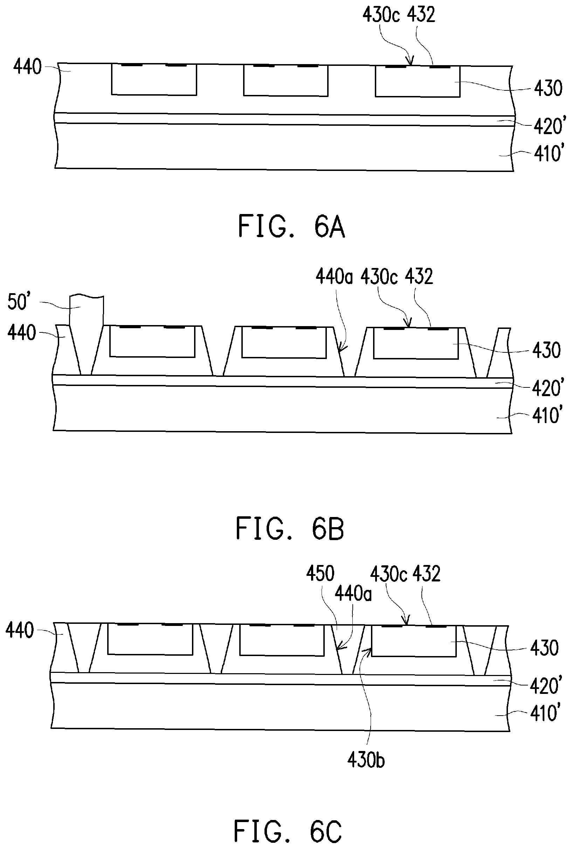

In some variation examples of this embodiment, a side surface of the ring-shape barrier may be inclined with respect to a side surface of the LED chip to further increase light output efficiency. The variation examples are described in detailed with reference to FIG. 5A to FIG. 5C and FIG. 6A to FIG. 6F.

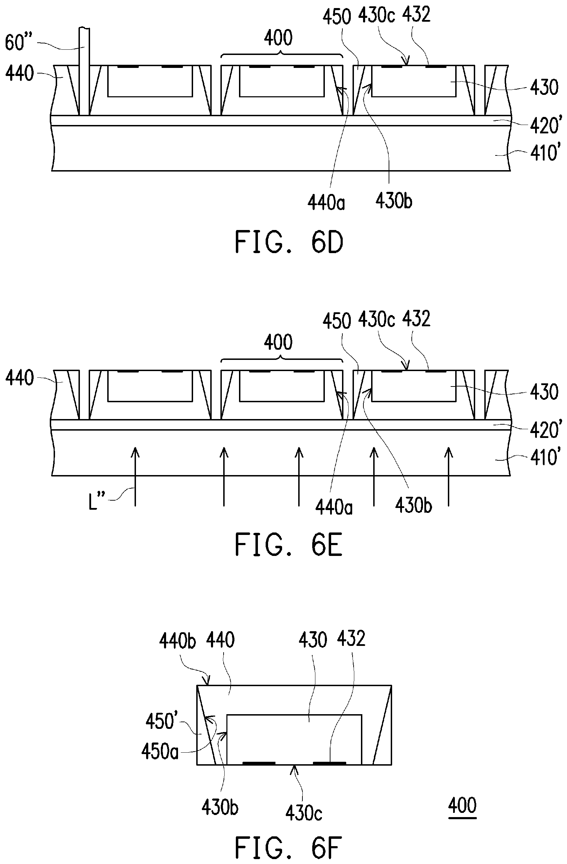

With reference to FIG. 6F first, to be specific, a difference between a LED device 400 of this variation example and the LED device 200 includes that an encapsulant 440 is shaped as an inverted trapezoid, and a reflection surface 450a of a ring-shape barrier 450' is inclined with respect to a side surface 430b of a LED chip 430. That is, a distance between the reflection surface 450a and the side surface 430b gradually decreases in a direction away from a light output surface 440b. Accordingly, the reflection surface 450a can more effectively reflect light rays towards the light output surface 440b, so as to further increase light output efficiency of the LED device 400. In this variation example, the reflection surface 450a is a plane type inclined wall. Nevertheless, the invention is not limited thereto, and the reflection surface may be a curved-surface wall of a concave surface type, a convex surface type, or a surface of a suitable type in other embodiments. The shape of the reflection surface may be designed and formed through adopting different types of a cutting tool 50'.

A method of manufacturing the LED device of this embodiment is described in detail with reference to FIG. 5A to FIG. 5C and FIG. 6A to FIG. 6F.

Specifically, after the steps of FIG. 5A to FIG. 5C of the second embodiment are performed, the encapsulant 440 and the LED chips 430 are flipped over and are adhered onto another carrier 410' having a soluble adhesive layer 420' as shown in FIG. 6A. After the encapsulant 440 and the LED chips 430 are flipped over, the carrier 410' is then de-bonded and separated, and that a bottom surface 430c of each of the LED chips 430 faces upwards. As shown in FIG. 6B, the encapsulant 440 is then pre-cut through a cutting tool 50' to form a patterned trench 440a in the encapsulant 440, wherein each of the LED chips 430 is surrounded by the patterned trench 440a. To be specific, the cutting tool 50' of this variation example has an inclined surface 50a. When the encapsulant 440 is pre-cut through the cutting tool 50', the surface 50a of the cutting tool 50' is inclined with respect to a side surface 430b of each of the LED chips 430 and corresponds to an inner wall of the patterned trench 440a. Accordingly, the inner wall of the patterned trench 440a is inclined with respect to the side surface 430b of each of the LED chips 430 as shown in FIG. 6B.

Next, as shown in FIG. 6C, a reflection colloid 450 is then formed in the patterned trench 440a, as such, the reflection colloid 450 is distributed between the LED chips 430. Corresponding to the inclined inner wall of the patterned trench 440a, a cross-section of the reflection colloid 450 is shaped as a letter V as shown in FIG. 6C. In other variable example, a cross-section of the ring-shape barrier may also be shaped as a letter U. As shown in FIG. 6D, the reflection colloid 450 is then cut through a cutting tool 60" to perform singulation to the encapsulant 440 and the flip chips 430 to form a plurality of LED devices 400. Finally, as shown in FIG. 6E, a light ray L" is provided, and the light ray L" irradiates the soluble adhesive layer 420', so as to reduce adhesiveness of the soluble adhesive layer 420'. As such, each of the LED devices 400 can be separated from the soluble adhesive layer 420' and the light transmissive carrier 410' so as to be in a state shown in FIG. 6F. In addition, as described above, a quality test may be performed to each of the LED devices 400 after de-bonding to determine whether each of the LED chips 400 achieves the expected light output effect.

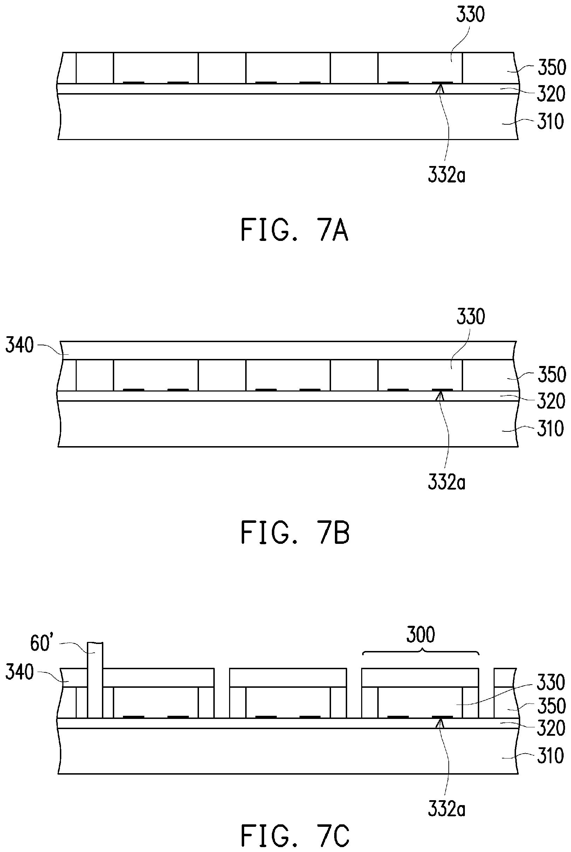

In some variation examples of this embodiment, the encapsulant may be entirely disposed on the LED chips and the ring-shape barrier, and moreover, the ring-shape barrier is in contact with the LED chips directly. The variation example is described in detail with reference to FIG. 5A to FIG. 5B and FIG. 7A to FIG. 7E.

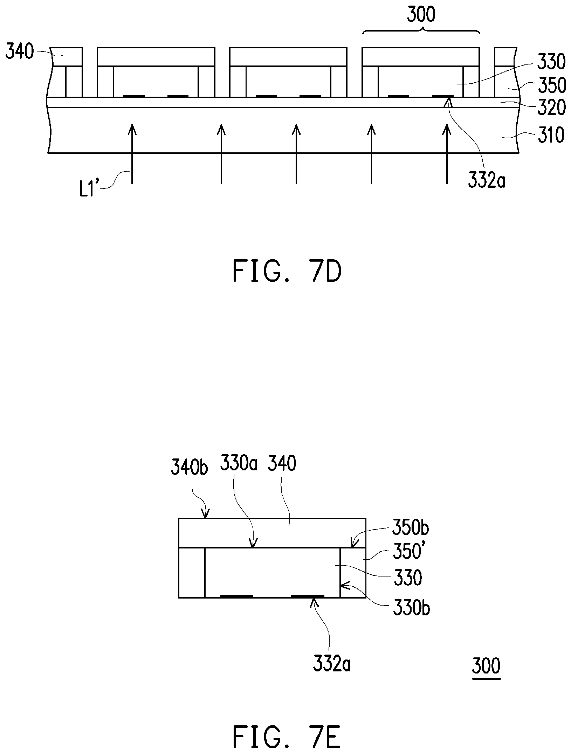

With reference to FIG. 7E first, to be specific, a difference between a LED device 300 of this variation example and the LED device 100 includes that an encapsulant 340 does not extend between a side surface 330b of a LED chip 330 and a ring-shape barrier 350', and the ring-shape barrier 350' directly covers the side surface 330b of the LED 330. Accordingly, a light ray emitted by the LED chip 330 is more concentrated to be emitted from a light output surface 340b to increase light output efficiency, and a quantity of the encapsulant 340 to be used can be reduced to save material costs. In addition, different from a top surface 250b of the ring-shape barrier 250' of FIG. 4 which is coplanar with the light output surface 240b of the encapsulant 240, a top surface 350b of the ring-shape barrier 350' in this variable example is coplanar with a top surface 330a of the LED chip 330.

A method of manufacturing the LED device of this embodiment is described in detail with reference to FIG. 5A to FIG. 5B and FIG. 7A to FIG. 7E.

Specifically, after the steps of FIG. 5A to FIG. 5B of the second embodiment are performed, a reflection colloid 350 is formed on a soluble adhesive layer 320 as shown in FIG. 7A, wherein the reflection colloid 350 fills gaps between the LED chips 330. As shown in FIG. 7B, an encapsulant 340 is then formed on the LED chips 330 and the reflection colloid 350, wherein the encapsulant 340 covers the LED chips 330, and the encapsulant 340 does not cover electrode terminals 332a of LED chips 330.

As shown in FIG. 7C, the encapsulant 340 and the reflection colloid 350 are then cut through a cutting tool 60' to perform singulation to the encapsulant 340 and the LED chips 330 to form a plurality of LED devices 300. As shown in FIG. 7D, a light ray L' is provided to reduce adhesiveness of the soluble adhesive layer 320. As such, each of the LED devices 300 can be separated from the soluble adhesive layer 320 and the light transmissive carrier 310 so as to be in a state shown in FIG. 7E. Finally, as described above, a quality test may be performed to each of the LED devices 300 after de-bonding to determine whether each of the LED chips 300 achieves the expected light output effect.

In the first embodiment and the second embodiment of this invention, the height of the ring-shape barrier and the height of the encapsulant are equal. Nevertheless, a LED device in which a height of a ring-shape barrier and a height of an encapsulant are unequal is also provided in the invention so as to further adjust the light output angle. A third embodiment is provided to give detailed description.

### Third Embodiment

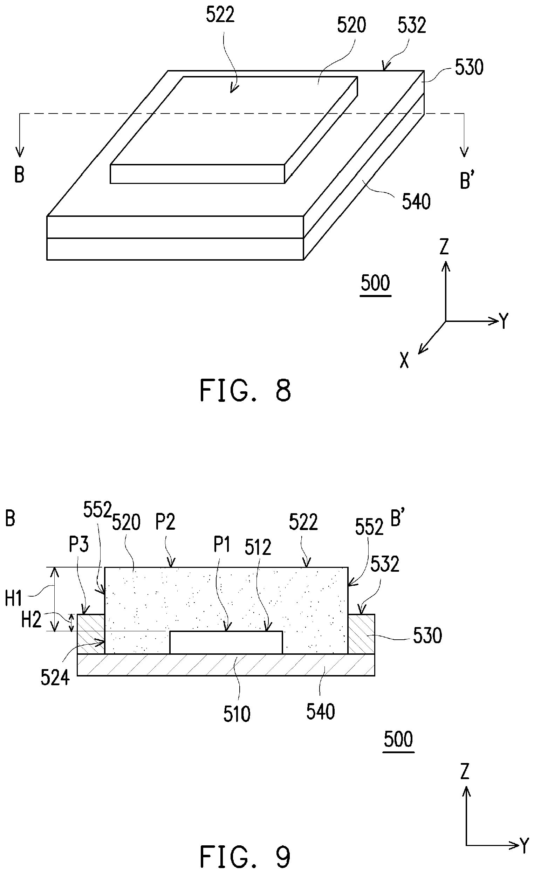

FIG. 8 and FIG. 9 are a three-dimensional view and a cross-sectional view of a LED device of the third embodiment of the invention, wherein FIG. 8 is a schematic cross-sectional view taken along a line B-B' of the three-dimensional view of FIG. 9. To be specific, different from the first embodiment and the second embodiment, in the third embodiment, a LED chip 510 has a first surface 512, an encapsulant 520 has a second surface, 522, and a ring-shape barrier 530 has a third surface 532. The second surface 522 is higher than the third surface 532. The first surface 512 and the second surface 522 define a first height H1, and the first surface 512 and the third surface 532 define a second height H2. In this embodiment, if the first surface, the second surface, and the third surface are inclined surfaces, vertical heights of highest points (i.e., end points) after the first surface, the second surface, and the third surface are projected are defined as the first height H1 and the second height H2. If surfaces of the components are plane surfaces, any point on the plane surface is the "end point", and the height is a vertical distance between two end points. For instance, since top surfaces having plane surfaces of the LED chip 510, the encapsulant 520, and the ring-shape barrier 530 are taken as an example in this embodiment, any point on the first surface 512 of the LED chip 510 can be defined as a first end point PI, any point on the second surface 522 of the encapsulant 520 can be defined as a second end point P2, and any point on the third surface 532 of the ring-shape barrier 530 can be defined as a third end-point P3.

In this way, in this embodiment, the first height H1 may be defined by the first end point P1 of the first surface 512 and the second end point P2 of the second surface 522, and the second height H2 may be defined by the first end point P1 of the first surface 512 and the third end-point P3 of the third surface 532. Accordingly, since the second surface 522 of this embodiment is higher than the third surface 532, the first height H1 is greater than the second height H2. That is, the third end-point P3 is closer to the first end point P1 than the second end point P2 based on the first end point P1. In other words, based on the LED chip 510, a height of the ring-shape barrier 530 (taking the third end-point P3 on the third surface 532 as the highest point) is lower than a height of the encapsulant 520 (taking the second end point P2 on the second surface 522 as the highest point).

Note that the concept of changing the ring-shape barrier in the third embodiment may be applied to the LED device with a substrate and the LED device without a substrate, that is, the third embodiment may be combined with the first embodiment or the second embodiment. Forms in which a substrate is present or not present is to be described as follows.

In addition, the degrees of roughness of the encapsulant and the ring-shape barrier may be adjusted to change the light output efficiency. Further, in the third embodiment, a degree of roughness of a fourth surface 552 (i.e., a side surface of the encapsulant 520 exposed outside the ring-shape barrier 530) can be adjusted to further change the light output efficiency. For instance, the second surface 522 may be similar to a flat surface, and the fourth surface 552 may be a rough surface, and that the degree of roughness of the fourth surface 552 is greater than that of the second surface 522. Alternatively, the third surface 532 of the ring-shape barrier 530 may also be designed to be a rough surface, and a degree of roughness of the third surface 532 may be similar to that of the fourth surface 552. In addition, in order to increase refraction of light emitted by the fourth surface 552, preferably, an area of the third surface 532 may be increased. Since the entire area of the third surface 532 is greater than an entire area of the fourth surface 552. Nevertheless, the invention is not limited thereto. Those having ordinary skill in the art may change a proportion of the third surface 532 to the fourth surface 552 according to application requirements.

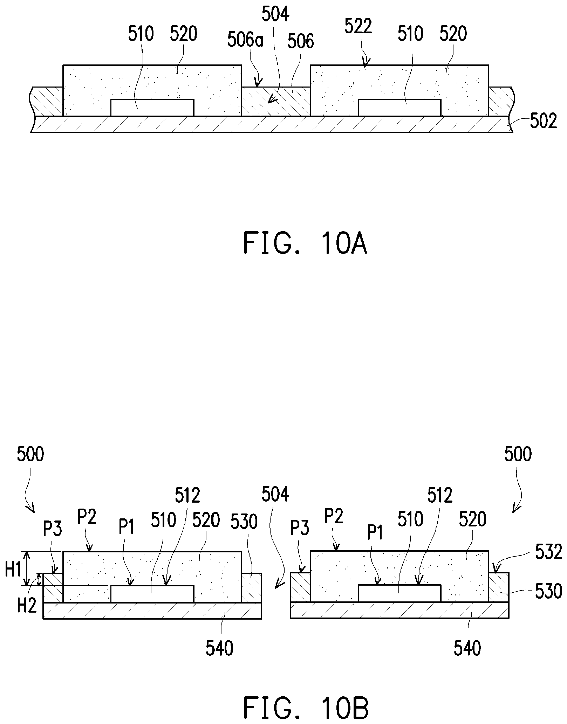

A method of manufacturing the LED device of the third embodiment is described in detail with reference to FIG. 3A to FIG. 3D and FIG. 10A to FIG. 10B.

To be specific, after the steps of FIG. 3A to FIG. 3D are performed, a portion of a reflection colloid 506 is removed as shown in FIG. 10A, such that a top surface 506a of the reflection colloid 506 is lower than the second surface 522 of the encapsulant 520. That is, the reflection colloid 506 which is as high as the encapsulant 520 in FIG. 3D is lower than the encapsulant 520 in this step. In addition, in this step, a method of removing a portion of the reflection colloid 506 includes removing a portion of the reflection colloid 506 in a direction parallel to a carrier 502. In this case, the top surface 506a of the reflection colloid 506 is a plane and is parallel to the carrier 502. Further, in the step of removing a portion of the reflection colloid 506, a height of the reflection colloid 506 relative to the carrier 502 may be greater than the height of the LED chip 510 relative to the carrier 502. That is, the reflection colloid 506 is lower than the encapsulant 520 but is higher than the LED chip 510.

In the step of FIG. 10B, the reflection colloid 506 is then cut along a trench 504 so that the reflection colloid 506 becomes a plurality of the ring-shape barriers 530, that is, the singulation step described above. The ring-shape barriers 530 correspondingly surround the LED chip 510 and the encapsulant 520. Each of the ring-shape barriers 530 has the third surface 532 to define the third end-point P3. The first surface 512 and the corresponding third surface 532 define the second height H2, wherein the first height H1 is greater than the second height H2. To be specific, the form shown in FIG. 10 is a LED device with a substrate. When singulation is performed, the carrier 502 is required to be simultaneously or subsequently cut to form the LED device 500 with a substrate 540.

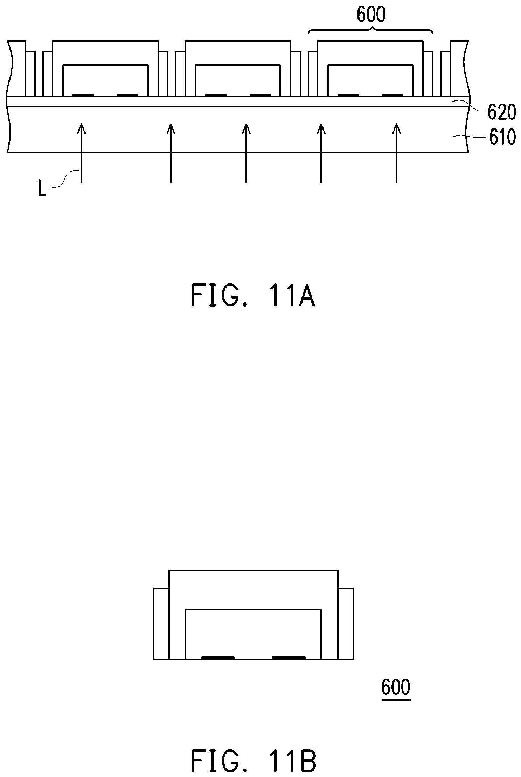

Further, as regards a LED device without a substrate, the LED device 500 may be formed right after an adhesive layer 506 is cut. At this time, the carrier 502 may be selectively cut or may not be selectively cut, and the LED device 500 and the carrier 502 are separated subsequently (i.e., forming the LED device 500 without a substrate). In this case, in the step of FIG. 3A, a light transmissive carrier similar to the light transmissive carrier 210 having the soluble adhesive layer 220 as shown in FIG. 5A may be provided. After the singulation step, a light ray L may be provided to irradiate a soluble adhesive layer 620 to reduce adhesiveness of the soluble adhesive layer 620 as shown in FIG. 11A. As such, each of the LED devices 600 can be separated from the soluble adhesive layer 620 and a light transmissive carrier 610 so as to be in a state shown in FIG. 11B. Similarly, a quality test may be performed to each of the LED devices 600 after de-bonding to determine whether each of the LED chips 600 achieves the expected light output effect.

To prove the effect brought by changing the height of the ring-shape barrier in the invention, light output intensities in different axis directions of the LED device with different heights of the ring-shape barrier are measured and are provided as follows.

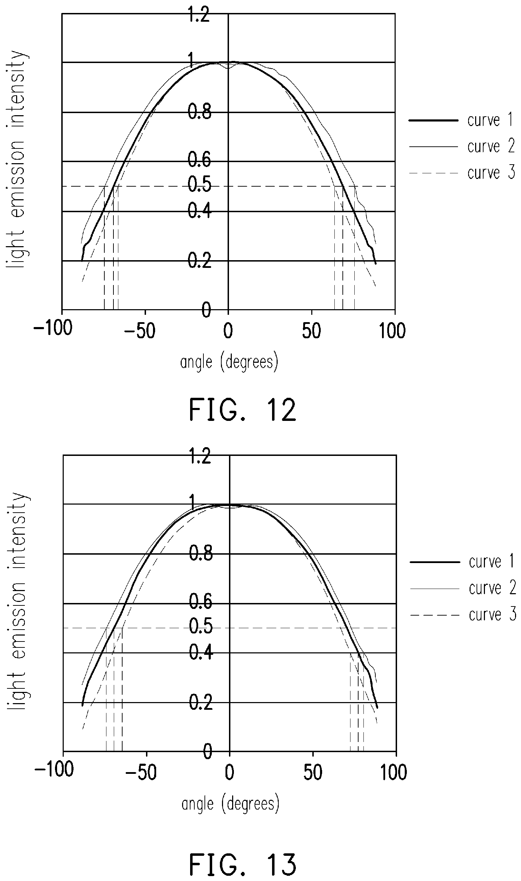

FIG. 12 and FIG. 13 are graphs of light output intensity of the LED device of FIG. 9 and other LED devices at each angle on an X axis and a Y axis in a space coordinate system. With reference to FIG. 8, FIG. 9, FIG. 12, and FIG. 13, as described above, the ring-shape barrier 530 is adapted to reflect light rays emitted by the LED chip 510 and the encapsulant 520 in this embodiment. That is, structural design of the ring-shape barrier 530 affects light output effect (e.g., light output angle) of the LED device 500. The "light output angle" refers to an angle range of a ratio greater than 0.5 of a light output volume of the LED device 500 at each angle on a plane (i.e., the viewing angle shown in FIG. 9) constituted by a Z axis (i.e., an axis direction perpendicular to a light emission surface of the LED chip 510) on which the LED device 500 is located and a single axis direction on an XY plane (i.e., the X axis or the Y axis) to the light output volume of the LED device 500 at 0 degree (i.e., a Z axis direction) when the LED device 500 is placed in a space coordinate system XYZ.

Taking light output intensity of the LED device 500 at each angle on the X axis in the space coordinate system (i.e., FIG. 12) for example, a ratio of the light output volumes of the LED device 500 (the height of the ring-shape barrier 530 is half of the height of the encapsulant 520, as shown in FIG. 9) at +65 degrees and - 65 degrees (i.e., the curve 1) to the light output volume of the LED device 500 at 0 degree (i.e., the Z axis direction) is 0.5. As such, the light output angle of the LED device 500 is 530 degrees (covering +65 degrees and -65 degrees). In contrast, comparing to the LED device of the first embodiment (the height of the ring-shape barrier and the height of the encapsulant are equal, as shown in FIG. 2), a ratio of light output volumes of the LED device of the first embodiment at +60 degrees and -60 degrees (i.e., the curve 3) to the light output volume of the LED device of the first embodiment at 0 degree (i.e., the Z axis direction) is 0.5. As such, the light output angle of the LED device of the first embodiment is 120 degrees (covering +60 degrees and -60 degrees). In addition, although an emission angle of the LED device is further expanded (approximately 140 degrees) if the ring-shape barrier is omitted (i.e., the curve 2), the light rays can not be concentrated through reflection, and that light output brightness and light output uniformity are considerably lowered. It thus can be seen that the LED device 100 of the third embodiment (the curve 1) has a greater emission angle on an axis direction X compared to the LED device of the first embodiment (the curve 3); nevertheless, the effect of light ray concentration through reflection originally provided by the ring-shape barrier 530 is maintained. Similarly, taking light output intensity of the LED device 100 at each angle on the Y axis in the space coordinate system (i.e., FIG. 13) for example, the LED device 500 of the third embodiment (the curve 1) has a greater emission angle on an axis direction Y compared to the existing LED device (the curve 3), and moreover, the effect of light ray concentration through reflection originally provided by the ring-shape barrier 530 is maintained.

Through the description of FIG. 12 and FIG. 13, it thus can be seen that the effect of changing the light output angle is provided in the LED device of the third embodiment compared to that of the first embodiment. In addition, when the light output angle is required to be slightly expanded owing to market demand, people having ordinary skill in the art may change the structure of the LED device 500 with reference to the invention and do not have to re-design the lenses to satisfy the demand. It thus can be seen that the LED device 500 provided by the invention features favorable industrial applications.

As such, under the foregoing concept, besides the LED device 500 shown in FIG.9, other variation examples may also be used to adjust the emission angle of the LED device as described by the invention, and LED devices provided by the variation examples may also be manufactured through steps similar to that provided above. Several variation examples in line with the same technical concept are provided as follows.

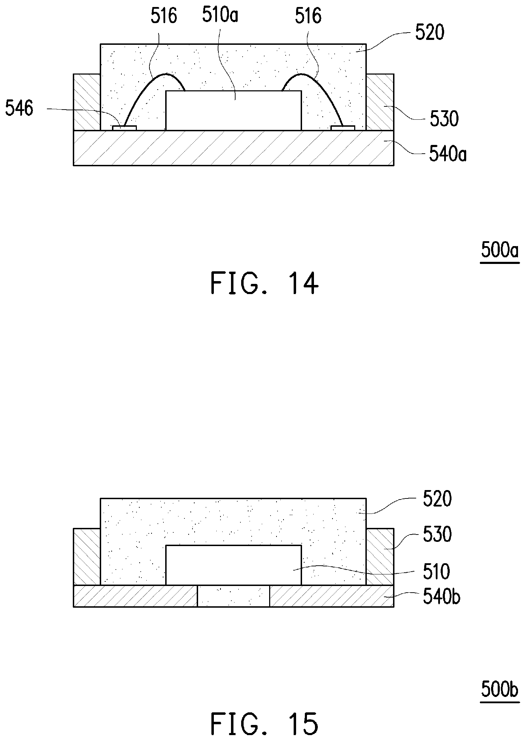

FIG. 14 to FIG. 25 are schematic cross-sectional views of a LED device of other variation examples of this embodiment. With reference to FIG. 14 first, in this variation example, a LED device 500a includes a LED chip 510a, the encapsulant 520, the ring-shape barrier 530, and a substrate 540a. A structure of the LED device 500a is similar to that of the LED device 500, and a difference therebetween includes that the LED chip 510 shown in FIG. 9 is a flip chip electrically connected to a circuit pattern (not shown) on the substrate 540 through a flip-chip bonding process, but the LED chip 510a of this variation example is a horizontal chip. An electrode of the LED chip 510a is located at an upper side of the LED chip 510a and is required to be connected to an circuit pattern 546 on the substrate 540a through a plurality of wires 516 after the LED chip 510a is disposed on the substrate 540a. Accordingly, when the LED device 500a is manufactured through the foregoing manufacturing method, the step in which the LED chip 510a is disposed on the substrate 540a acting as the carrier 502 (shown in FIG. 10A) includes a wire bonding process, that is, the LED chip 510a is electrically connected to the substrate 540a through the wires 516. It thus can be seen that the type of the LED chip and the specific technical method in which the LED chip is electrically connected to the substrate are not limited by the invention and may be adjusted as required.

With reference to FIG. 15, in this variation example, a LED device 500b includes the LED chip 510, the encapsulant 520, the ring-shape barrier 530, and a substrate 540b. A structure of the LED device 500b is similar to that of the LED device 500, and a difference therebetween includes that the substrate 540 is a one-piece substrate, such as a ceramic substrate, a plastic substrate, or a printed circuit substrate, but the substrate 540b of this variation example is a metal substrate and is a separated substrate. To be specific, the LED chip 510 is electrically connected to the substrate 540b through the electrode of the LED chip 510, and portions of the substrate 540b being connected to the electrode are separated from each other so as to avoid occurrence of a short circuit. In this way, the LED device 500b may also be manufactured through the foregoing manufacturing method. Accordingly, the type of the substrate is not limited by the invention and may be adjusted as required. In addition, gaps in the substrate 540 may be filled with or may not be filled with the encapsulant 520 corresponding to process differences.

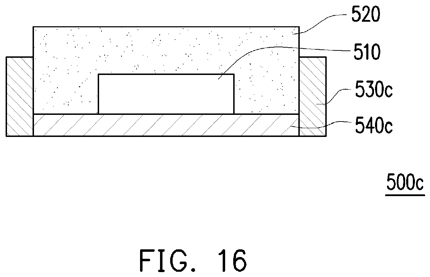

With reference to FIG. 16, in this variation example, a LED device 500c includes the LED chip 510, the encapsulant 520, a ring-shape barrier 530c, and a substrate 540c. A structure of the LED device 500c is similar to that of the LED device 500, and a difference therebetween is that the ring-shape barrier 530 surrounds the encapsulant 520 and the LED chip 510 and is located on the top surface 542 of the substrate 540, but the ring-shape barrier 530c of this variation example surrounds the encapsulant 520 and the LED chip 510 and further surrounds the substrate 540c. That is, the ring-shape barrier 530c is located outside the LED chip 510, the encapsulant 520, and the substrate 540c and is located on an outer surface 544 of the substrate 540c. Therefore, when the LED device 500c is manufactured through the foregoing manufacturing method, the carrier 502 may be simultaneously or subsequently cut during the step in which the encapsulant is cut, as such, the patterned trench 504 extends into the carrier 502. The steps of forming the reflection colloid 506, removing a portion of the reflection colloid 506, and cutting the reflection colloid 506 as shown in FIG. 10A to FIG. 10B and are performed subsequently. Finally, the ring-shape barrier 530c surrounds the outer surface 544 of the substrate 540c. To be specific, when the encapsulant is cut, the trench 504 extends into the entire carrier 502 as shown in FIG. 16. Nevertheless, in the invention, the carrier 502 is not limited to be entirely cut, and it may be that only a portion of the carrier 502 is cut. That is, the ring-shape barrier 530c may extend into only a portion of the carrier 502 (or a side wall of the substrate 540) and do not penetrate the carrier 502. It thus can be seen that a positional relation between the ring-shape barrier and the substrate is not limited by the invention and may be adjusted as required.

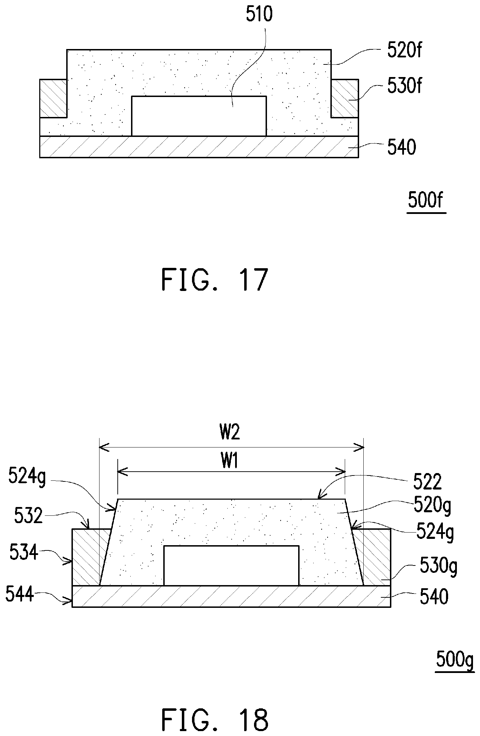

With reference to FIG. 17, in this variation example, a LED device 500f includes the LED chip 510, an encapsulant 520f, a ring-shape barrier 530f, and the substrate 540. A structure of the LED device 500f is similar to that of the LED device 500, and a difference therebetween includes that the ring-shape barrier 530 is disposed on the top surface 542 of the substrate 540 and is in contact with the substrate 540, but the ring-shape barrier 530f of this variation example is located above a portion of the encapsulant 520. That is, the ring-shape barrier 530f is not in contact with the substrate 540, and a portion of the encapsulant 520 extends between the ring-shape barrier 530f and the substrate 540. Therefore, when the LED device 500f is manufactured through the foregoing manufacturing method, in the step of cutting the encapsulant 520f and forming the patterned trench 504, the cut encapsulant 520f is not exposed outside the surface of the substrate 540. The reflection colloid 506 filling the patterned trench 504 subsequently constitutes the ring-shape barrier 530f and is located above a portion of the encapsulant 520f. It thus can be seen that a relation position between the ring-shape barrier and the substrate is not limited by the invention and may be adjusted as required.

With reference to FIG. 18, in this variation example, a LED device 500g includes the LED chip 510, an encapsulant 520g, a ring-shape barrier 530g, and the substrate 540. A structure of the LED device 500g is similar to that of the LED device 500, and a difference therebetween includes that each side surface 524 of the encapsulant 520 is perpendicular to the substrate 540 and that the encapsulant 520 has a uniform thickness in a vertical direction, but each side surface 524g of the encapsulant 520g of this variation example is an inclined surface. Moreover, a height of the side surface 524g decreases from one end adjacent to the LED chip 510 towards the other end away from the LED chip 510, and that a width of the encapsulant 520g increases towards the substrate 540 (or the carrier). In other words, a width W1 of a second surface 522 of the encapsulant 520g is less than a width W2 of a bottom surface of the encapsulant 520g in contact with the substrate 540, and that a cross-section of the encapsulant 520g is shaped as a trapezoid. Therefore, when the LED device 500g is manufactured through the foregoing manufacturing method, in the step of cutting the encapsulant 520g, a cutting tool with an inclined surface is used to cut the encapsulant 520g, and that the side surface 524g of the encapsulant 520g is shaped as an inclined surface as well.

Further, in the variation example in FIG. 18, corresponding to the encapsulant 520g being disposed, an external side surface 534 of the ring-shape barrier 530g may be maintained to be a plane with reference to the embodiment of FIG. 9 and is flushed with an external side surface 544 of the substrate 540. In this way, a width of the ring-shape barrier 530g decreases towards the substrate 540 (or the carrier), and that a cross-section of the ring-shape barrier 530g is shaped as a trapezoid or a triangle. Therefore, when the LED device 500g is manufactured through the foregoing manufacturing method, the adhesive layer 506 configured for forming the ring-shape barrier 530g fills into the trench 504 and covers the side surface 524g shaped as an inclined surface on the encapsulant 520g. The adhesive layer 506 is then cut in the vertical direction in the step of FIG. 10B, as such, the external side surface 534 of the ring-shape barrier 530g is shaped as a plane and is flushed with the side surface 544 of the substrate 540.

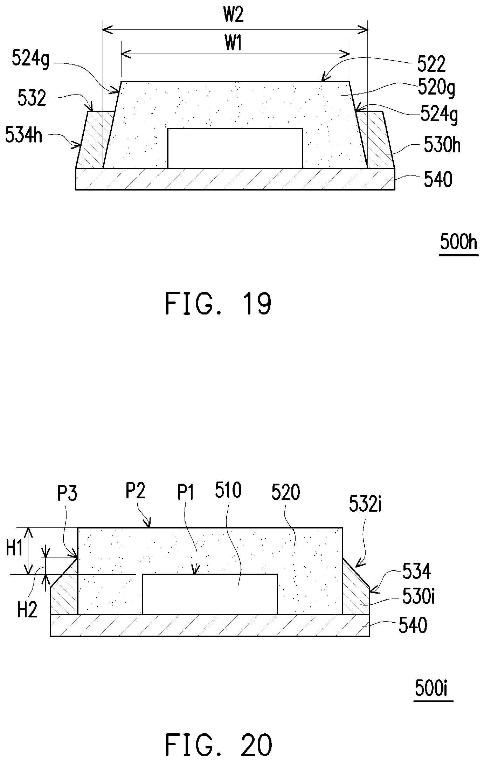

In the variation example of FIG. 19, a LED device 500h features the design identical to that of the encapsulant 520g; nevertheless, each external side surface 534h of a ring-shape barrier 530h of the LED device 500h is an inclined surface. The external side surface 534h refers to the side surface on the ring-shape barrier 530h which is not in contact with the encapsulant 520. As such, a height of the external side surface 534h decreases from one end adjacent to the LED chip 510 towards the other end away from the LED chip 510, and that a cross-section of the ring-shape barrier 530h is shaped as a trapezoid or a triangle and may also be shaped as a parallelogram (i.e., the external side surface 534h is parallel to the side surface 524g). Therefore, when the LED device 500h is manufactured through the foregoing manufacturing method, the adhesive layer 506 configured for forming the ring-shape barrier 530h fills into the trench 504 and covers the side surface 524g shaped as an inclined surface on the encapsulant 520g. In the step of FIG. 10B, the adhesive layer 506 is then cut in a direction inclined with respect to the carrier 502/the substrate 540 rather than in the vertical direction by a cutting tool with an inclined surface, as such, the external side surface 534h of the ring-shape barrier 530h is shaped as an inclined surface.

Similarly, in the variation example of FIG. 20, a LED device 500i includes the LED chip 510, the encapsulant 520, a ring-shape barrier 530i, and the substrate 540. A structure of the LED device 500i is similar to that of the LED device 500, and a difference therebetween includes that the third surface 532 of the ring-shape barrier 530 is a plane, but a third surface 532i of the ring-shape barrier 530i of this variation example is shaped as an inclined surface. As such, a height of the third surface 532i decreases from one end adjacent to the LED chip 510 towards the other end away from the LED chip 510. That is, one end of the third surface 532i in contact with the encapsulant 520 is higher than the other end of the third surface 532i in contact with an external side surface 534. Therefore, when the LED device 500i is manufactured through the foregoing manufacturing method, in the step of removing a portion of the adhesive layer 506 (i.e., the step of FIG. 10A), the portion of the adhesive layer 506 is also removed in a direction inclined with respect to the carrier 502/the substrate 540, as such, the third surface 532i of the ring-shape barrier 530i is shaped as an inclined surface. At this time, a third end-point P3 of the ring-shape barrier 530i is located at a highest point of the third surface 532i, and that the second height H2 is defined by the third point P3 under such circumstances. In thus can be seen that the shapes of the encapsulant and the ring-shape barrier are not limited by the invention based on the embodiment of FIG. 18 to FIG. 20 and may be adjusted as required.

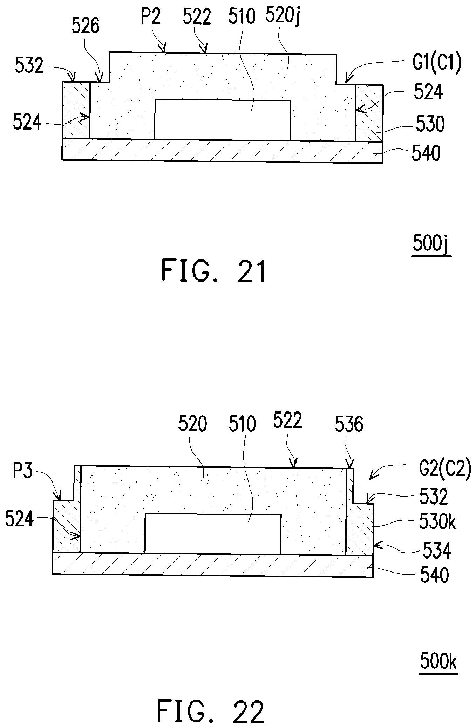

With reference to FIG. 21, in this variation example, a LED device 500j includes the LED chip 510, an encapsulant 520j, the ring-shape barrier 530, and the substrate 540. A structure of the LED device 500i is similar to that of the LED device 500, and a difference therebetween includes that the juncture C1 of the second surface 522 of the encapsulant 520 and each side surface 524 is formed at the right angle, but a step G1 is provided at a juncture C1 of a second surface 522 of the encapsulant 520j and each side surface 524 of this variation example and that a stair-shaped structure is formed. Moreover, the step G1 of the encapsulant 520j has a step surface 526 connected to the ring-shape barrier. In other words, the juncture C1 is recessed towards an inner portion of the encapsulant 520j. As such, the second surface 522 is higher than the step surface 526 to form the step-shaped structure, and a second end point P2 of the encapsulant 520j is located on the second surface 522.

In addition, in this variation example, the step surface 526 and a third surface 532 of the ring-shape barrier 530 may further form a continuous surface. That is, a height of the step surface 526 is equal to a height of the third surface 532. Nevertheless, the invention is not limited thereto, and the third surface 532 may be higher than or lower than the step surface 526. Therefore, when the LED device 500j is manufactured through the foregoing manufacturing method, in the step of removing a portion of the adhesive layer 506 (i.e., the step of FIG. 10A), a portion of the encapsulant 520j is also removed, and that a periphery of the encapsulant 520j (i.e., the juncture C1) is shaped as a step-shaped structure to constitute the step G1. Moreover, the step surface 526 is as high as the third surface 532 of the ring-shape barrier 530.

Similarly, in the variation example of FIG. 22, a LED device 500k includes the LED chip 510, the encapsulant 520, a ring-shape barrier 530k, and the substrate 540. A structure of the LED device 500k is similar to that of the LED device 500, and a difference therebetween includes that the ring-shape barrier 530k is not entirely cut and that a top surface 536 of the ring-shape barrier 530k is created. A thickness of the top surface 536 is relatively thin, and that light transmissive effect of a certain degree is provided. Hence, in this embodiment, the top surface 356 is not the third surface. A step G2 is provided at a juncture C2 of the top surface 536 and each external side surface 534 of the ring-shape barrier 530k, and that a step-shaped structure is formed. Moreover, the step G2 has a step surface to constitute a third surface 532. That is, the step G2 of the ring-shape barrier 530k has the step surface connected to the corresponding external side surface 534, and the step surface is the third surface 532 under such circumstances. In other words, the juncture C2 is recessed towards an inner portion of the ring-shape barrier 530, as such, the top surface 536 is higher than the step surface (the third surface) to be shaped as the stair-shaped structure.

In addition, in this variable example, the top surface 536 of the ring-shape barrier 530k and the second surface 522 of the encapsulant 520 may further form a continuous surface. That is, a height of the top surface 536 is equal to a height of the second surface 522. At this time, the third surface 532 is lower than the second surface 522 of the ring-shape barrier 530k. Nevertheless, the invention is not limited thereto, and adjustment may be made according to requirements. Therefore, when the LED device 500k is manufactured through the foregoing manufacturing method, in the step of removing a portion of the reflection colloid 506 (i.e., the step of FIG. 10A), a width of the portion of the reflection colloid 506 being removed (i.e., the step G2 of the ring-shape barrier 530k) is less than a half of a width of the trench 504 (shown in FIG. 10A), preferably less than a quarter. That is, in the step of removing a portion of the reflection colloid 506, the side surface 524 of the encapsulant 520 is not exposed. As such, the top surface 536 of the ring-shape barrier 530k and the second surface 522 of the encapsulant 520 forms a continuous surface, and the step G2 shaped as a stair structure if formed at the juncture C2.

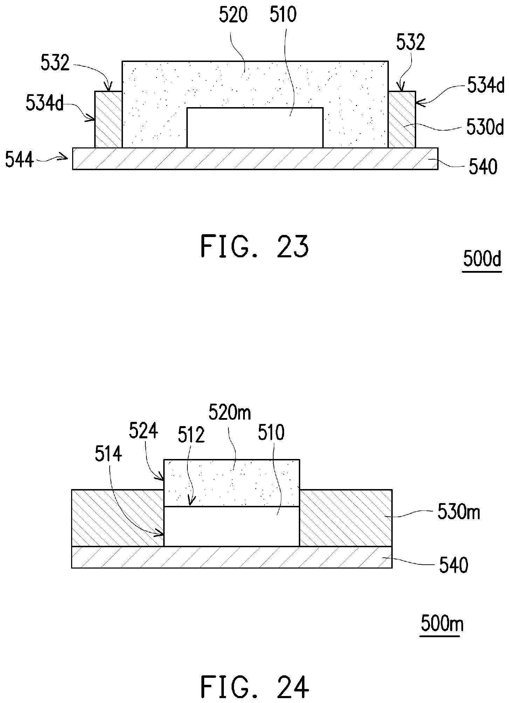

With reference to FIG. 23, in this variation example, a LED device 500d includes the LED chip 510, the encapsulant 520, a ring-shape barrier 530d, and a substrate 540. A structure of the LED device 500d is similar to that of the LED device 500, and a difference therebetween includes that the substrate 534 of the ring-shape barrier 530 is flushed with the external side surface 544 of the substrate 540, but an external side surface 534d of the ring-shaped barrier 530d of this variation example is not aligned with the external side surface 544 of the substrate 540. That is, a drop is provided between the external side surface 534d and the external side surface 544. Therefore, when the LED device 500d is manufactured through the foregoing manufacturing method, in the step of cutting the reflection colloid 506 along the trench 504 (i.e., the step of FIG. 10B), the reflection colloid 506 is cut in a direction perpendicular to the carrier 502, and then the carrier 502 is sequentially cut at a translation cutting position. As such, the external side surface 534d of the ring-shape barrier 530d is not flushed with the external side surface 544 of the substrate 540 acting as the carrier 502.

It thus can be seen that when the LED device is singulated, the ring-shape barrier and the substrate may be cut simultaneously through the same process step. As such, the external side surface of the ring-shape barrier and the external side surface of the substrate are flushed (as shown in FIG. 9). The ring-shape barrier and the substrate may also be cut independently through different process steps, and that the external side surface of the ring-shape barrier and the external side surface of the substrate are not flushed (as shown in FIG. 24).

With reference to FIG. 24, in this variation example, a LED device 500m includes the LED chip 510, an encapsulant 520m, a ring-shape barrier 530m, and the substrate 540. A structure of the LED device 500m is similar to that of the LED device 500, and a difference therebetween includes that the encapsulant 520 covers the first surface 512 and a side surface 514 of the LED chip 510, but the encapsulant 520m of this variation example covers only the first surface 512 of the LED chip 510 and is not in contact with the side surface 514 of the LED chip 510 nor the substrate 540. A side surface 524 of the encapsulant 520m may further be flushed with the side surface 514 of the LED chip 510. Note that in order to increase bonding strength between the encapsulant 520m and the LED chip 510, a connection surface between the encapsulant 520m and the LED chip 510 is lower than a height of the ring-shape barrier 530m. Hence, the ring-shape barrier 530m may be used to additionally increase the bonding strength between the encapsulant 520m and the LED chip 510, as such, the encapsulant 520m is prevented from being released from the LED chip 510 owing to heat generated by the LED chip 510.

Therefore, when the LED device 500m is manufactured through the foregoing manufacturing method, in the step in which the encapsulant 520m is formed on the carrier 502, a fluorescence patch may be used instead to act as the encapsulant 520m to be attached to the LED chip 510, and the step in which a portion of the encapsulant is removed is omitted. Next, in the step from FIG. 10A to FIG. 10B, the ring-shape barrier 530m is formed through filling the patterned trench 504 with the reflection colloid 506 and may cover a side surface 524 of the encapsulant 520m and the side surface 514 of the LED chip 510. It thus can be seen that a forming method of the encapsulant is not limited by the invention and may be adjusted as required. The shapes of the encapsulant and the ring-shape barrier and the positional relation between the ring-shape barrier and the substrate are not limited by the invention based on the embodiment of FIG. 22 to FIG. 24 and may be adjusted as required.

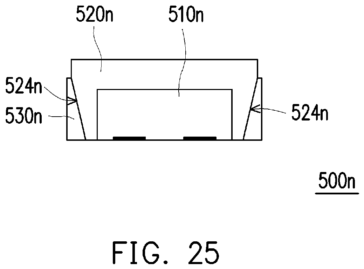

With reference to FIG. 25, in this variation example, a LED device 500n includes a flip chip 510n, an encapsulant 520n, and a ring-shape barrier 530n. A structure of the LED device 500n is similar to that of the LED device 500, and a difference therebetween includes that the LED device 500 includes the substrate 540, and the LED device 500n of this variation example does not include the substrate 540. In addition, each side surface 524 of the encapsulant 520 is perpendicular to the substrate 540 and that the encapsulant 520 has a uniform thickness in the vertical direction, but a portion of each side surface 524n of the encapsulant 520n in contact with the ring-shape barrier 530n of this variation example is an inclined surface, and that a width of the encapsulant 520n increases bottom up. As described above, for instance, the LED device 400 shown in FIG. 6E is flipped over to be upside down and then is cut to form the LED device 500n shown in FIG. 25. A method of flipping over may be performed through using the light transmissive carrier having the soluble adhesive layer as described in the second embodiment, and then the carrier is separated through light radiation.

Note that although various structural features of the LED device are described in this embodiment, implementation of the embodiment is not limited thereto. In other words, the structural features may also be combined to be implemented. For instance, the LED chip 510a (bonded to the substrate through the wires 516) described in FIG. 14 or the substrate 540b (a metal substrate) described in FIG. 15 may be applied to the LED device of FIG. 16 to FIG. 25. Alternatively, other possible implementations (e.g., the first embodiment, the second embodiment, and the similar variation examples) may also be used to achieve the goal of changing the height of the ring-shape barrier to change the light output angle of the LED device provided by the invention.

In view of the foregoing, in the LED device provided by some embodiments of the invention, the ring-shape barrier aligned to the side surfaces of the LED chip is disposed around the LED chip. A portion of a lateral light emitted by the LED chip may at least be reflected towards the light output surface of the LED device by the ring-shape barrier and is outputted from the light output surface. In this way, light output efficiency of the LED device is increased, the problem of non-uniform light-emitting color (e.g., yellow halo) is mitigated, and light output uniformity of the LED device is enhanced. In addition, the reflection surface of the ring-shape barrier may be designed to be inclined with respect to the side surface of the LED chip. As such, the light ray can be reflected towards the light output surface of the LED device more effectively through the reflection surface, so as to further increase light output efficiency. Further, in the LED device and the method of manufacturing the same in some embodiments of the invention, the height of the ring-shape barrier is lower than the height of the encapsulant. In this way, comparing to the existing technology in which the ring-shape barrier is manufactured to be as high as the encapsulant, the height of the ring-shape barrier is further adjusted in the manufacturing process to be lower than that of the encapsulant in the embodiment of the invention. The height of the ring-shape barrier affects the light output angle of the LED device. Therefore, the LED device and the method of manufacturing the same in the embodiment of the invention are adapted to adjust the light output angle of the LED device. Moreover, the LED device provided by the embodiment of the invention can satisfy changes in market demand without re-designing the lenses and thus features favorable industrial applications.

Finally, it is worth noting that the foregoing embodiments are merely described to illustrate the technical means of the invention and should not be construed as limitations of the invention. Even though the foregoing embodiments are referenced to provide detailed description of the invention, people having ordinary skill in the art should understand that various modifications and variations can be made to the technical means in the disclosed embodiments, or equivalent replacements may be made for part or all of the technical features; nevertheless, it is intended that the modifications, variations, and replacements shall not make the nature of the technical means to depart from the scope of the technical means of the embodiments of the invention.

## Claims

1. A light emitting diode (LED) device, comprising:
a LED chip, having a first surface and a side surface;
a encapsulant, having a second surface, the encapsulant covering the LED chip; and
a ring-shape barrier, surrounding the encapsulant, the ring-shaped barrier having a reflection surface;
wherein the reflection surface is inclined with respect to the side surface of the LED chip.

2. The LED device as claimed in claim 1, wherein the LED chip is a flip chip, the flip chip has a plurality of electrode terminals, and the electrode terminals are exposed outside the encapsulant.

3. The LED device as claimed in claim 2, wherein a gap between the electrode terminals and a bottom surface of the encapsulant is between 3µm and 20µm.

4. The LED device as claimed in claim 3, wherein a distance between the reflection surface and the side surface of the LED chip gradually decreases in a direction away from the second surface.

5. The LED device as claimed in claim 3, wherein the reflection surface is a convex surface or a concave surface.

6. The LED device as claimed in claim 1, wherein the encapsulant further comprises a bottom surface exposed between chip electrodes and the ring-shape barrier.

7. The LED device as claimed in claim 6, wherein an area of the bottom surface is equal to or less than 20% of an area of the second surface.

8. The LED device as claimed in claim 1, wherein the second surface is a rough surface.

9. The LED device as claimed in claim 1, wherein a width of the ring-shaped barrier is 0.05 to 0.4 times of a width of the LED chip.

10. The LED device as claimed in claim 1, wherein a cross section of the encapsulant is shaped as a trapezoid.

11. The LED device as claimed in claim 1, wherein the ring-shape barrier has a third surface, the first surface and the second surface define a first height, and the first surface and the third surface define a second height, wherein the first height is greater than the second height.

12. The LED device as claimed in claim 1, comprising a substrate, the LED chip and the encapsulant being disposed on the substrate.

13. The LED device as claimed in claim 12, wherein the LED chip is electrically connected to the substrate through a wire.

14. The LED device as claimed in claim 12, wherein the ring-shape barrier is disposed on the substrate.

15. The LED device as claimed in claim 12, wherein the ring-shape barrier surrounds a side surface of the substrate.
